## Europäisches Patentamt

## European Patent Office

## Office européen des brevets

(19)

(11) Veröffentlichungsnummer: **0 222 038**
**B1**

(12) **EUROPÄISCHE PATENTSCHRIFT**

(45) Veröffentlichungstag der Patentschrift:
**10.05.89**

(21) Anmeldenummer: **85114395.8**

(22) Anmeldetag: **13.11.85**

(51) Int. Cl.⁴: **H01R 9/26**

(54) **Reihenklemme.**

(43) Veröffentlichungstag der Anmeldung:
**20.05.87 Patentblatt 87/21**

(45) Bekanntmachung des Hinweises auf die Patenterteilung:
**10.05.89 Patentblatt 89/19**

(84) Benannte Vertragsstaaten:
**CH DE FR GB IT LI NL**

(56) Entgegenhaltungen:
**FR-A- 2 165 070**
**FR-A- 2 532 811**
**US-A- 2 740 193**

**ELEKTROTECHNISCHE ZEITSCHRIFT, Band 103, Nr. 20,
November 1982, Seiten 1152-1154, Berlin; H.W. WIDER:
"Elektronik in der Klemme"
GALVANOTECHNIK, Band 72, Nr. 4, April 1981, Saulgau;
H. KÜNZIG: "Photopolymeres Epoxhydharz als
Lötstop- und Isolierlack"**

(73) Patentinhaber: **C.A. Weidmüller GmbH & Co.,
Postfach 950 Paderborner Strasse 175,
D-4930 Detmold 14(DE)**

(72) Erfinder: **Lush, Steven, 29 Timbercroft, Ewell Epsom
Surrey(GB)**
Erfinder: **Kerbstat, Siegfried, Am Geeren 31,
D-4930 Detmold(DE)**

(74) Vertreter: **Loesenbeck, Karl-Otto, Dipl.-Ing. et al,
Jöllenbecker Strasse 164, D-4800 Bielefeld 1(DE)**

## Beschreibung

Die Erfindung betrifft eine Reihenklemme mit einem Isolierstoffgehäuse mit mindestens einer seitlichen Abschlußwand.

Derartige Reihenklemmen sind bezüglich der in ihnen verwirklichten Anschlußtechniken, der Etagenzahl und der Ausgestaltung des Gehäuses in den verschiedensten Ausführungen bekannt. Gemeinsam ist ihnen, daß im Inneren des Isoliestoffgehäuses neben den diversen Anschlußstücken und den diese verbindenden Stromschienen Freiräume vorhanden sind, die bislang entweder ungenutzt sind, oder teilweise zum Einsatz von speziell angepaßten kleinen Leiterplatten mit darauf befindlichen elektrisch/elektronischen Bauelementen genutzt werden. Noch aufwendiger ist die bisher auch übliche freie Verdrahtung einzelner Bauelemente innerhalb der Klemmenräume.

Der vorliegenden Erfindung liegt von daher die Aufgabe zugrunde, eine Reihenklemme zu schaffen, die auf denkbar einfache Weise ohne Zwischenschaltung von zusätzlichen Leiterplatten die Verwirklichung elektrisch/elektronischer Schaltungen und weiterer Anschlüsse in ihrem Isolierstoffgehäuse ermöglicht.

Die erfindungsgemäße Lösung besteht darin, daß das Isolierstoffgehäuse aus einem hoch temperaturbeständigen Material besteht und Freizonen der Innenseite der seitlichen Abschlußwand des Isolierstoffgehäuses mit Leiterbahnen für die Oberflächenmontage von elektrisch/elektronischen Elementen bedruckt sind.

Es hat sich dabei gezeigt, daß die Bildung derartiger Freizonen auf der Innenseite der seitlichen Abschlußwand durch Verlagerung und teilweise auch Fortlassung dort häufig sonst vorgesehener Versteifungsstege, Rastelemente zur Verbindung mit dem nachfolgenden Isolierstoffgehäuse in einer Reihenklemmenanordnung und dergleichen problemlos gebildet werden können. Es hat sich gezeigt, daß die Innenseiten derartiger Reihenklemmenabschlußwände auch mit Leiterbahnen bedruckt werden können, wozu sich beispielsweise die fotomechanische Bedruckung gut eignet. Zum Einsatz kommen dabei elektrisch/elektronische Elemente, die für die sogenannte Oberflächenmontage geeignet sind, die also insbesondere auf die Leiterbahnen aufgeklebt werden können, da insbesondere Anschlußtechniken, die eine Durchbrechung der seitlichen Abschlußwand des Isolierstoffgehäuses nach außen bedingen würden, nicht zum Einsatz kommen können. Im Sinne der Oberflächenmontage werden dann die Isolierstoffgehäuse zusammen mit den aufgeklebten Elementen durch ein Lötbad geleitet, um insoweit auch die elektrische Verbindung zwischen den Leiterbahnen und den Elementen zu gewährleisten. Da bei der hier in Frage kommenden Technik Temperaturen über 200° auftreten können, muß das Isolierstoffgehäuse einer derartigen Reihenklemme in diesem Sinne hoch temperaturbeständig sein. Bevorzugt in diesem Sinne sind beispielsweise Gehäuse aus Epoxidharz. Es kann aber ohne weiteres auch keramisches Material zur Bildung der Isolierstoffgehäuse zum Einsatz kommen.

Unter elektrisch/elektronischen Elementen sind nicht nur Bauelemente zur Bildung entsprechender Schaltungen zu verstehen. Es können beispielsweise auf diese Weise auf den Leiterbahnen auch Drahtstücke mechanisch und elektrisch fest angeordnet werden, die dann mit der oder den Stromschienen funktionsentsprechend elektrisch leitend, beispielsweise durch Löten, verbunden werden können.

Bei dieser Ausgestaltung besteht einmal die Möglichkeit, daß der Hersteller der Reihenklemme lediglich die mit den bedruckten Leiterbahnen versehenen Reihenklemmen zur Verfügung stellt und es dem Anwender überläßt, welche elektrisch/elektronischen Schaltungen und Anschlüsse er hier zusätzlich mit Hilfe der Oberflächenmontage verwirklichen will. Besonders zweckmäßig ist hier jedoch, wenn bei derartigen Reihenklemmen schon gleich herstellerseitig bestimmte, immer wieder benötigte Schaltungen und Anschlußmöglichkeiten verwirklicht werden und diese dann gleich in integrierter Form mit der Reihenklemme bzw. einem aus diesen Reihenklemmen gebildeten Klemmenblock zur Verfügung gestellt werden.

Bevorzugte Ausgestaltungen einer Reihenklemme gemäß der Erfindung sind in den Unteransprüchen gekennzeichnet.

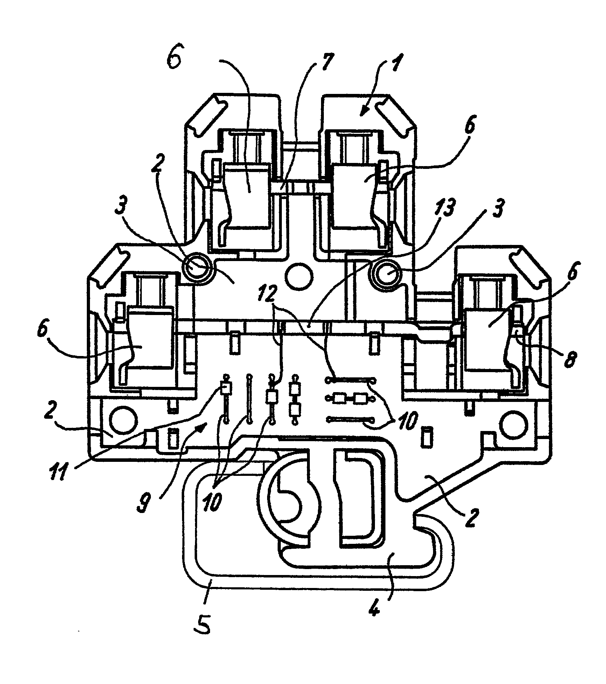

Ein Ausführungsbeispiel einer Reihenklemme gemäß der Erfindung wird nachstehend unter Bezugnahme auf die Zeichnung beschrieben.

Die Zeichnung zeigt eine einseitig offene Reihenklemme gemäß der Erfindung in Seitenansicht.

Im dargestellten Ausführungsbeispiel ist eine einseitig offene Doppelstock-Reihenklemme vorgesehen, die ein Isolierstoffgehäuse 1 mit nur einer seitlichen Abschlußwand 2 hat und Rastelemente 3 zum Verrasten mit benachbarten Reihenklemmengehäusen innerhalb der Anreihung in einem Klemmenblock aufweist. An dem Isolierstoffgehäuse 1 ist der übliche Rastfuß 4 zum Aufrasten der Reihenklemme auf einer Normtragschiene 5 gebildet.

Im dargestellten Ausführungsbeispiel ist in der Doppelstock-Reihenklemme die Schraubanschlußtechnik verwirklicht. In beiden Etagen sind jeweils zwei übliche Zugbügelanschlüsse 6 angeordnet, die untereinander jeweils in den Etagen durch Stromschienen 7 und 8 in Verbindung stehen.

Im dargestellten Ausführungsbeispiel ist nun unterhalb der unteren Stromschiene 8 auf der Innenseite der seitlichen Abschlußwand 2 durch Fortlassung bzw. Unterbrechung und Verlagerung von Verstärkungsrippen, Angußstücken, Rastelementen und dergleichen eine ebenflächige Freizone 9 gebildet, und in dieser Freizone 9 sind auf die Innenseite der Abschlußwand 2 des Isolierstoffgehäuses 1 Leiterbahnen 10 aufgedruckt, wozu sich eine fotomechanische Bedruckung besonders eignet. Elektrisch/elektronische Elemente, beispielsweise in Form diverser Bauelemente 11, werden in der Oberflächenmontagetechnik mechanisch fest und elektrisch leitend mit den Leiterbahnen 10 auf diesen festgesetzt. Hierzu werden die elektrisch/elektronischen Bauelemente 11 insbesondere zunächst aufgeklebt und das Isolierstoffgehäuse 1 mit den aufgedruckten Leiterbahnen 10 und den aufgeklebten

Bauelementen 11 wird durch ein Lötbad geführt, mit dem die elektrische Verbindung zwischen den Leiterbahnen 10 und den Bauelementen 11 erzeugt wird. Bei dieser bekannten Verbindungstechnik können im Lötbad Temperaturen von über 200° auftreten, so daß Isolierstoffgehäuse 1 in diesem Sinne hoch temperaturbeständig zu sein hat. Es kann beispielsweise aus einem Epoxidharz bestehen. Es kann aber auch aus einem keramischen Material bestehen.

Es können ferner auch in Oberflächenmontagetechnik auf den Leiterbahnen 10 elektrische Elemente in Form einfacher Leiterdrahtstücke 12 festgesetzt werden, die dann zur Erstellung elektrischer gewünschter Verbindungen mit ihrem anderen Ende an die Stromschiene 8 angelötet werden, wozu diese zweckmäßig mit Kerben 13 versehen ist.

Es versteht sich, daß abweichend vom dargestellten Ausführungsbeispiel die geschilderte Bildung von Freizonen und deren geschilderte Ausnutzung auch bei nur einstöckigen oder bei drei- und mehrstöckigen Reihenklemmen verwirklicht werden kann und daß dies auch bei Reihenklemmen geschehen kann, die ganz oder teilweise mit einer anderen Anschlußtechnik als dem Schraubanschluß ausgerüstet sind.

## Patentansprüche

1. Reihenklemme mit einem Isolierstoffgehäuse (1) mit mindestens einer seitlichen Abschlußwand, dadurch gekennzeichnet, daß das Isolierstoffgehäuse (1) aus einem hoch temperaturbeständigen Material besteht und mindestens eine Freizone (9) der Innenseite der seitlichen Abschlußwand mit Leiterbahnen für die Oberflächenmontage von elektrisch/elektronischen Elementen (11, 12) bedruckt ist.

2. Reihenklemme nach Anspruch 1, dadurch gekennzeichnet, daß die Leiterbahnen (10) durch einen fotomechanischen Druck gebildet sind.

3. Reihenklemme nach Anspruch 1 oder 2, dadurch gekennzeichnet, daß die elektrisch/elektronischen Elemente (11, 12) aufgeklebt und mit den Leiterbahnen (10) im Lötbad verlötet sind.

4. Reihenklemme nach einem der Ansprüche 1–3, dadurch gekennzeichnet, daß die Freizonen (9) ebenflächig ausgebildet sind.

5. Reihenklemme nach einem der Ansprüche 1–4, dadurch gekennzeichnet, daß das Isolierstoffgehäuse aus Epoxidharz besteht.

6. Reihenklemme nach einem der Ansprüche 1–4, dadurch gekennzeichnet, daß das Isolierstoffgehäuse (1) aus keramischem Material besteht.

## Claims

1. A modular terminal member comprising a housing (1) of insulating material with at least one lateral closure wall, characterised in that the insulating material housing (1) comprises a highly temperature-resistant material and at least one free zone (9) of the inward side of the lateral closure wall is printed with conductor tracks for the surface mounting of electrical/electronic elements (11, 12).

2. A modular terminal member according to claim 1 characterised in that the conductor tracks (10) are formed by a photomechanical printing operation.

3. A modular terminal member according to claim 1 or claim 2 characterised in that the electrical/electronic elements (11, 12) are secured by adhesive and are soldered to the conductor tracks (10) in a solder bath.

4. A modular terminal member according to one of claims 1 to 3 characterised in that the free zones (9) have a flat surface.

5. A modular terminal member according to one of claims 1 to 4 characterised in that the insulating material housing comprises epoxy resin.

6. A modular terminal member according to one of claims 1 to 4 characterised in that the insulating material housing (1) comprises ceramic material.

## Revendications

1. Barrette à bornes avec un boîtier en matériau isolant (1) présentant au moins une paroi terminale latérale, caractérisée en ce que le boîtier en matériau isolant (1) est réalisé en un matériau à haute résistance à la température, et en ce qu'au moins une zone libre (9) du côté intérieur de la paroi terminale latérale est imprimée avec des pistes conductrices pour le montage en surface d'éléments électriques/électroniques (11, 12).

2. Barrette à bornes selon la revendication 1, caractérisée en ce que les pistes conductrices (10) sont formées par une impression photomécanique.

3. Barrette à bornes selon la revendication 1 ou 2, caractérisée en ce que les éléments électriques/électroniques (11, 12) sont collés et brasés sur les pistes conductrices (10) dans le bain de brasage.

4. Barrette à bornes selon l'une des revendications 1 à 3, caractérisée en ce que les zones libres (9) sont réalisées avec une surface plane.

5. Barrette à bornes selon l'une des revendications 1 à 4, caractérisée en ce que le boîtier en matériau isolant est réalisé en résine époxy.

6. Barrette à bornes selon l'une des revendications 1 à 4, caractérisée en ce que le boîtier en matériau isolant est réalisé en matériau céramique.